# EUROPEAN PATENT SPECIFICATION

(11) **EP 0 882 289 B1**
(45) Date of publication and mention of the grant of the patent: **06.08.2003**
(21) Application number: 97909530.4
(22) Date of filing: 06.11.1997
(51) Int. Cl.: G11B 5/127, G11C 11/15, G01R 33/06, H01L 43/00

(54) **LATERAL MAGNETO-ELECTRONIC DEVICE EXPLOITING A QUASI-TWO-DIMENSIONAL ELECTRON GAS**
SEITLICHE MAGENTO-ELEKTRONISCHE VORRICHTUNG UNTER AUSNUTZUNG EINES QUASI ZWEI-DIMENSIONALEN ELEKTROGASES
DISPOSIFIF MAGNETO-ELECTRONIQUE LATERAL EXPLOITANT UN GAZ D'ELECTRONS QUASI BIDIMENSIONNEL

(30) Priority: 02.12.1996 EP 96203404
(43) Date of publication of application: 09.12.1998
(73) Proprietor: Koninklijke Philips Electronics N.V., 5621 BA Eindhoven (NL)
(72) Inventor: LENSSEN, Kars-Michiel, Hubert, NL-5656 AA Eindhoven (NL)
(74) Representative: Faessen, Louis Marie Hubertus
(86) International application number: IB9701399
(87) International publication number: WO98025263

(56) References cited:
- EP-A- 0 450 912
- US-A- 5 432 373
- US-A- 5 565 695
- US-A- 5 654 566
- APPL. PHYS. LETT., Volume 56, No. 7, February 1990, SUPRIYO DATTA, BISWAJIT DAS, "Electronic Analog of the Electro-Optic Modulator", pages 665-667.

## Description

The invention relates to a magneto-electronic device comprising a substrate on which a first and a second body of magnetic material are provided, whereby the magnetization of at least the second body is not fixed.

The term "body" should here be interpreted as encompassing such objects as, for example, individual thin films, multilayer structures or thick films, all of which at least partially comprise magnetic material. The term "fixed" as employed with regard to magnetization has a relative meaning: the magnetization M₁ in a first body is fixed with respect to the magnetization M₂ in a second body if the external magnetic field strength H required to directionally reverse M₁ is higher than that required to reverse M₂. One way of fixing the magnetization direction in a magnetic body is to exchange-bias it; alternatively, if the coercive field of the first body exceeds that of the second, or if the first body has a larger shape anisotropy, then the magnetization of the first body may be regarded as being fixed.

A device as specified in the opening paragraph is known from International Patent Application WO 95/22820, which describes a trilayer structure comprising two layers of magnetic material which are separated by and magnetically coupled across an interposed non-metallic layer (comprising, for example, a semiconductor, semi-metal or insulator material). One of the layers of magnetic material has a fixed magnetization direction ― achieved using a technique such as exchange-biasing, for example ― whereas the magnetization in the other magnetic layer is free to rotate. By connecting the magnetic layers to opposite poles of a controllable voltage source, an electric field can be applied across the non-metallic-interlayer; in this manner, the strength and nature of the magnetic coupling across the interlayer can be altered, thereby allowing alteration of the relative orientation of the magnetizations in the two magnetic layers. Exploiting this effect, the device can, for example, be employed as a magnetic write head or a magnetic random-access memory (MRAM).

The known device has a number of disadvantages. For example, the voltages required to alter the coupling across the interlayer (typically of the order of five volts, or more) are relatively high. In addition, because of the stacked nature of the device, the distance between the magnetic layers is relatively small (of the order of a few nanometers), so that the interlayer cannot be accessed directly in order to influence its properties in a more refined or localized manner.

It is an object of the invention to provide a new type of magneto-electronic device. In particular, it is an object of the invention that the constituent parts of this device be more accessible, so as to allow more refined influencing of the device's performance. In addition, it is an object of the invention that it be possible to influence the properties of the new device using not only an electric field but also various other agents. Moreover, it is an object of the invention that the new device should have a lower operating voltage than the known device.

These and other objects are achieved according to the invention in a device as specified in the opening paragraph, characterized in that the two bodies are substantially coplanar and mutually isolated, and that the bodies are mutually connected via a layer of semiconductor material in which a quasi-two-dimensional electron gas can be generated, as to form a lateral configuration.

The term "two-dimensional electron gas" (2DEG) is used in reference to semiconductor structures in which, within a given plane, there is a relatively high (metallic) electron mobility, whereas, perpendicular to that plane, electrons are trapped in a potential well. 2DEGs are exploited in ordinary MOSFETs, for example, but their application in a device as specified in the previous paragraph has heretofore been unknown. The physics of 2DEGs is elucidated in brief in United States Patent US 4,996,570, and in greater detail in *Solid State Physics,* vol. 44, H. Ehrenreich and D. Turnbull (Eds.), Academic Press Inc., 1991, ISBN 0-12-607744-4, particularly pages 1-26. In a so-called "true 2DEG", only one sub-band in the potential well is occupied, and there is no scattering to higher sub-bands; on the other hand, in a so-called "quasi-2DEG", several sub-bands in the potential well are occupied (the mutual separation of the sub-bands being greater than the thermal energy kT at any given temperature T, where k is the Boltzmann constant). Throughout this text, the term "quasi-2DEG" or "quasi-two-dimensional electron gas" should be interpreted as encompassing true 2DEGs also. Some semiconductor structures contain an "intrinsic" quasi-2DEG which is present even in the absence of an applied electric field, whereas other structures demonstrate quasi-2DEG behaviour only in the presence of such a field: for this reason, the phrase "can be generated" as here employed should be interpreted as encompassing both of these possibilities.

The invention exploits *inter alia* the facts that a quasi-2DEG has a relatively large electronic mean free path (of the order of 0.2-0.5 µm) and a relatively high electron mobility (typically greater than 1.5 m²/Vs); consequently, the quasi-2DEG can, for example, mediate magnetic coupling between two magnetic bodies over a relatively large distance, allowing a lateral device geometry instead of the conventional stacked geometry. In addition, it is possible to modulate the electron density of a quasi-2DEG, while still preserving its metallic properties; as a result, if two magnetic bodies are only mutually connected *via* the quasi-2DEG, then magnetic interaction (coupling) between those bodies can be altered by adjusting the quasi-2DEG's electron density. Because of the said lateral geometry, the semiconductor layer in which the quasi-2DEG is generated can be freely accessed by actinic radiation beams, magnetic fields or gate electrodes, so that the quasi-2DEG's electron density can be influenced in a direct, localized and refined manner. In the case of adjustment with one or more gate electrodes, the voltages typically required (of the order of 1 volt) are substantially lower than those required in the known device. In addition, because it is freely accessible, the semiconductor layer can be structured into various forms (*e.g.* using lithographic techniques), so that its electrical resistance can be tailored to the requirements of a particular application (*e.g.* the layer can be endowed with a constriction, resulting in a high electrical resistance between the magnetic bodies). As will be elucidated in more detail hereunder, the device according to the invention can be used as the basis of magnetic field sensors, magnetic write heads, MRAMs. *etc*.

It should be noted that, in the device according to the invention, the layer of semiconductor material in which the quasi-2DEG is generated may, for example, be disposed only in the gap between the two isolated magnetic bodies, or it may be disposed as a layer on top of the substrate and beneath the magnetic bodies. It should also be explicitly noted that the inventive device is suitable for operation at room temperature, and therefore does not need to be cooled to cryogenic temperatures in order to work.

An advantageous embodiment of the device according to the invention is characterized in that the magnetization direction of the first body is fixed (using, for example, a technique as elucidated in the second opening paragraph). As will be elucidated in what follows, this measure lies at the heart of several of the inventive device's possible applications. However, it should be noted that M₁ does not necessarily have to be fixed: for example, the device according to the invention can still be used as a type of MRAM if both M₁ and M₂ are free to rotate: see (d) below.

A particular embodiment of the inventive device as specified in the previous paragraph is characterized in that the first and second body are mutually magnetically coupled (exchange-coupling or magnetostatic coupling). In such a case, seeing as the magnetization M₂ of the second body is not fixed but that the magnetization M₁ of the first body is fixed, it is possible to alter the relative orientation of M₁ and M₂ simply by changing the nature (sign) of the coupling between them. This opens up several possible applications for the inventive device, including, for example:
(a) A magnetic write head:
   By using an electric field or a light source to modulate the electron density in the semiconductor layer's quasi-2DEG according to a given binary data pattern, the coupling between the two magnetic bodies can be altered back and forth between ferromagnetic (F) and anti-ferromagnetic (AF) states, causing M₂ to correspondingly rotate back and forth so as to be parallel or anti-parallel to M₁, respectively. This modulation of the direction of M₂ can be used to write binary information on a neighbouring magnetic medium, such as a tape, disc or card;
(b) An MRAM:
   As in the above case, application or removal of an electric field (for example) to the semiconductor layer can be used to change the direction of M₂. In this manner, the inventive device can be used as a binary RAM, whereby one direction of M₂ represents a "0" and the opposite direction represents a "1". The particular binary bit represented by M₂ at a given time can, for example, be determined (read) by monitoring magnetooptical Kerr effects in the second body, or by embodying the second body as a spin-valve magneto-resistive trilayer and monitoring its electrical resistance. A specific advantage of the inventive device's lateral geometry in the case of an MRAM is that, because the first and second magnetic bodies can be further apart than in the case of a stacked structure, it is possible to influence one magnetic body (*e.g.* with a current carrying wire) without substantially influencing the other magnetic body.
Such devices will be elucidated in more detail in the Embodiments below.

In an alternative embodiment of the inventive device as specified in the previous paragraph, the first and second body are not mutually magnetically coupled.
Possible applications for such a device include, for example:
(c) A magnetic field sensor (magnetic read head):
   The device according to the invention demonstrates a substantial spin-valve magneto-resistance effect. In the absence of coupling between the first and second bodies, M₂ is free to rotate in response to a variable external magnetic flux. Since M₁ is directionally fixed, such rotation will continually change the mutual orientation of M₁ and M₂, and thus the electrical resistance between the first and second magnetic bodies. The device thus acts as a transducer, translating a variable magnetic flux into a correspondingly varying electrical signal;
(d) An MRAM:
   If both M₁ and M₂ are free to rotate, then an MRAM can be realized by employing two separate write lines (*i.e.* electrical tracks with which a magnetic field can be generated) to directly manipulate M₁ and M₂ separately. In this manner, M₁ and M₂ can be switched between parallel and anti-parallel configurations, thereby accordingly influencing the lateral electrical resistance R₁₂ of the MRAM (*via* the spin-valve magneto-resistance effect).
Such devices will be elucidated in more detail in the Embodiments below.

As has been demonstrated hereabove, various possible applications of the inventive device exploit the application of an electric field to the quasi-2DEG. A convenient _ way to produce such a (controllable) field is with the aid of an electrode (a so-called gate electrode or Schottky contact) provided against the layer of semiconductor material. In particular, if so desired or required, several such gate electrodes may be provided against the semiconductor layer, thus allowing different regions of the quasi-2DEG to be subjected to different electric fields; this allows, for example, the creation of a so-called resonant-tunnelling multiple-barrier structure in the quasi-2DEG (a lateral version of a device as elucidated in International Patent Application WO 96/11469). In addition, if so desired, the gate electrode(s) may be endowed with a particular geometrical form *(e.g.* using lithographic techniques).

In the embodiment elucidated in the previous paragraph, the gate electrode(s) may be provided in direct contact with the semiconductor layer. Alternatively, the gate electrode(s) may be electrically insulated from the layer of semiconductor material. Such insulation may, for example, be achieved by providing a layer of dielectric material (such as SiO₂) between the gate electrode(s) and the semiconductor layer. A separate insulating layer of this type is not necessary if, for example, there is a quantum well structure (*i.e*. a non-conductive (surface) layer) in the semiconductor layer in which the quasi-2DEG is generated.

In general, at least one of the magnetic bodies in the inventive device will be connected to an electrical terminal, and, if required by a particular application, both magnetic bodies can be connected to different electrical terminals. However, if so desired, the inventive device may also comprise other ohmic contacts (terminals). For example, using a total of four contacts (*e.g*. on a single sheet of quasi-2DEG semiconductor material), one can make a planar Hall-effect device, in which the current-flow between two magnetic contacts is substantially perpendicular to the voltage gradient measured between two metallic contacts; such a device (excepting that it does not employ a quasi-2DEG) is, for example, elucidated by A. Schuhl *et al*. in Appl. Phys. Lett. 66 (1995), pp 2751-2753. Use of the Hall geometry in, for example, a magnetic field sensor employing the inventive device allows a significant noise reduction to be achieved.

For optimal performance, the occurrence of Schottky barriers at the interface between the magnetic bodies and the semiconductor layer should be avoided. In this light, an advantageous embodiment of the device according to the invention is characterized in that the semiconductor material comprises InAs. InAs demonstrates an accumulation layer at its surface (forming a quasi-2DEG), so that most metals deposited on clean InAs will form an ohmic contact. A suitable alternative to pure InAs is, for example, InₓGa₁₋ₓAs (in which the quantity of Ga is relatively small, *e.g.* x ≥ 0.8).

Suitable substrate materials for use in the device according to the invention include, for example, silicon wafers and InP, among others. Suitable magnetic materials for use in the first and second magnetic bodies include, for example, Fe, Ni, Co, various binary and ternary alloys of these materials (such as permalloy), CoZrNb and FeNbZrN, among others. It should be noted that the first and second magnetic bodies need not have the same constitution, shape or dimensions.

The invention and its attendant advantages will be further elucidated with the aid of exemplary embodiments and the accompanying schematic drawings, whereby:
Figure 1 renders a cross-sectional view of a semiconductor layer in which a quasi-2DEG can be generated;
Figure 2 is a cross-sectional depiction of a device according to the invention, here embodied as a magnetic field sensor;
Figure 3 depicts a modification of the subject of Figure 2, suitable for use as a magnetic write head;
Figure 4 depicts a modification of the subject of Figure 2, suitable for use as an MRAM;
Corresponding features in the various Figures are denoted by the same reference symbols.

### Embodiment 1

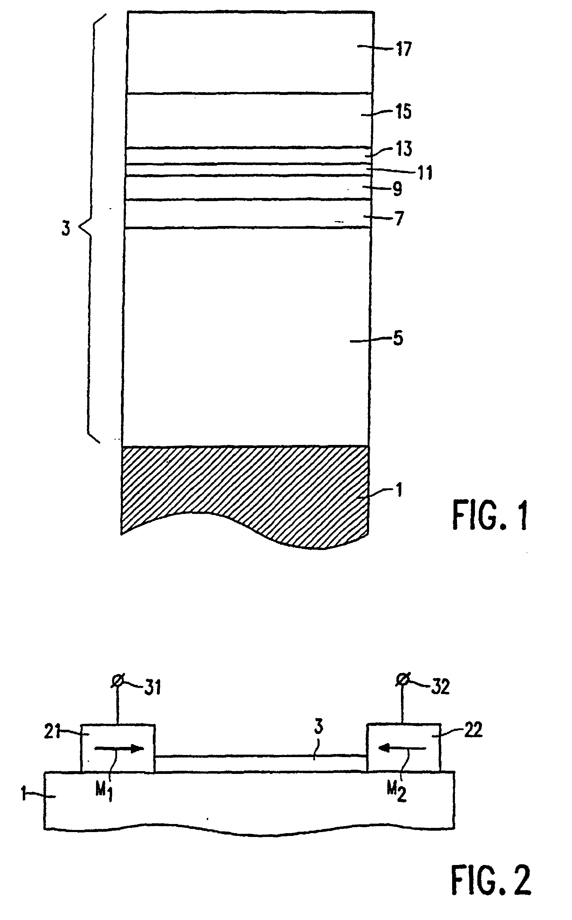

Figure 1 renders a cross-sectional view of a particular embodiment of a semiconductor layer 3 which is suitable for use in a device according to the invention and in which a quasi-2DEG can be generated. The layer 3 is deposited on a substrate 1, which in this case is comprised of InP. The layer 3 has a composite structure, with the following composition:

| item | material | thickness |
|---|---|---|
| 5 | ud InAlAs | 200 nm |
| 7 | n⁺ InAlAs | 7 nm |
| 9 | ud InAlAs | 6 nm |
| 11 | ud InGaAs | 2.5 nm |
| 13 | ud InAs | 4 nm |
| 15 | ud InGaAs | 13.5 nm |
| 17 | ud InAlAs | 20 nm |

In the table, "ud" indicates un-doped (*i.e.* intrinsic), and "n⁺" indicates donor-doping.

The depicted semiconductor layer 3 contains a quasi-2DEG in constituent layer 13 (in this particular case, a true, intrinsic 2DEG). This quasi-2DEG has an electron mobility of approx. 1.65 m²/Vs, an electron density of approx. 1.96 x 10¹⁶ m⁻² and_an electronic mean free path of approx. 0.4 µm.

### Embodiment 2

As an example of an alternative to the structure in Embodiment 1, a quasi-2DEG can also be generated in an MBE-grown semiconductor layer constituted as follows:
ud GaAs (17 nm)
n-doped Al_{0.33}Ga_{0.67}As (38 nm)
ud Al_{0.33}Ga_{0.67}As (41 nm)
ud GaAs (500 nm)
These constituents are listed in order of decreasing distance to the substrate, which may be comprised of GaAs, for example. The figures in parentheses indicate ideal thicknesses for the various constituents. The symbol "ud" indicates un-doped *(i.e.* intrinsic).

### Embodiment 3

Figure 2 shows a particular embodiment of a device according to the invention. The device comprises a substrate 1 on which a first magnetic body 21 and second magnetic body 22 are provided. The first body 21 has a magnetization M₁ and is connected to an electrical terminal 31, whereas the second body 22 has a magnetization M₂ and is connected to an electrical terminal 32. The bodies 21,22 may be comprised of permalloy, for example. As here depicted, the magnetizations M₁,M₂ have an in-plane direction, but they may also stand perpendicular to the substrate 1, for example (perpendicular anisotropy).

The magnetization M₂ is free to rotate under the influence of an external magnetic flux. However, the magnetization M₁ is directionally fixed by exchange-biasing the body 21 to an adjacent layer of exchange-biasing material, such as Fe₅₀Mn₅₀, which may, for example, be deposited on top of the body 21. Alternatively, the body 21 can be embodied to have a higher coercivity H_{c} than the body 22, *e.g.* by using different base materials for the bodies 21,22, or by using the same base material and doping it to different extents with a H_{c}-influencing additive (such as Os or Re). Yet another alternative is to endow the bodies 21,22 with different shape anisotropies, *e.g.* by embodying 22 as a disc (low shape anisotropy).

The first and second bodies 21,22 are mutually connected *via* a layer 3 of semiconductor material in which a quasi-2DEG can be generated *(e.g.* the layer 3 described in Embodiment 1). The arrangement of the bodies 21,22 and the layer 3 is such as to form a lateral configuration instead of a trilayer stack. The lateral distance between the bodies 21,22 is preferably of the same order of magnitude as the quasi-2DEG's electronic mean free path (typically about 0.2-0.5 µm). As here depicted, the layer 3 lies between the bodies 21,22; however, it may also lie under the bodies, as long as it provides a mutual connection.

The lateral separation of the bodies 21,22 is so large as to deter magnetic coupling between them. This will typically be the case for lateral separations of the order of about 0.25 - 0.5 µm, or more.

The sensor demonstrates a substantial spin-valve magneto-resistance effect, whereby the value of the electrical resistance R₁₂ measured between the terminals 31 and 32 depends on the relative orientation of M₁ and M₂ (in particular, whether they are parallel or anti-parallel). Exposure of the sensor to a variable external magnetic flux will cause M₂ to change its direction. Since M₁ is fixed, such exposure will change the relative orientation of M₁ and M₂, and thus also the value of R₁₂. In this way, a variable external magnetic flux can be converted into a correspondingly varying electrical signal, so that the device acts as a magnetic field sensor. In a particular application, the external magnetic flux emanates from a magnetic registration medium, such as a magnetic tape, disc or card moving in close proximity to the body 22, whence the device acts as a magnetic read head.

The device as depicted in Figure 2 may, of course, comprise additional parts to those depicted. In particular, the device may comprise flux guides, so as to concentrate external magnetic flux into the vicinity of the body 22.

### Embodiment 4

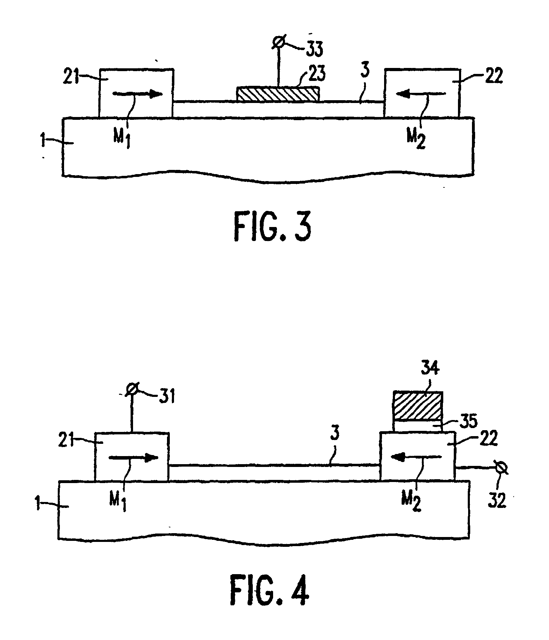

Figure 3 basically shows the device of Figure 2, subsequent to some modification. In particular:
- a gate electrode 23 has been provided against (upon) the layer 3, and this electrode 23 is connected to an electrical terminal 33;
- the terminals 31,32 in Figure 2 are absent in the present case;
- the magnetic bodies 21,22 are magnetically coupled. This may be realized by ensuring a sufficiently small lateral separation of the bodies 21,22 (*e.g.* of the order of about 100 nm).

As here depicted, the gate electrode 23 is in direct contact with the layer 3, but electrode 23 and layer 3 may also be mutually separated by an interposed layer of electrically insulating material (not depicted).

By applying an electrical voltage to the terminal 33, the layer 3 can be subjected to an electric field via the electrode 23, and this field can be used to alter the electron density of the quasi-2DEG in the layer 3. In particular, it is possible in this manner to alter the strength and/or sign (type) of the coupling between the bodies 21,22.

In a particular example, the coupling between the bodies 21,22 is intrinsically ferromagnetic (*e.g.* as a result of an exchange interaction), so that the magnetizations M₁ and M₂ are mutually parallel in the absence of an external magnetic flux. By applying a small DC voltage (of the order of 1 volt) to the terminal 33, the quasi-2DEG in the layer 3 is locally subjected to an electric field, causing the coupling between the bodies 21,22 to become antiferromagnetic (*e.g.* by electronically depleting the quasi-2DEG, so that the coupling between the bodies 21,22 becomes magnetostatic); as a result, since M₁ is fixed, M₂ will reverse its direction so as to be anti-parallel to M₁.

It is thus seen that application of a variable voltage to the terminal 33 can be used to cause the magnetization M₂ to flip back and forth in direction. Therefore, if a magnetic recording medium is moved close to the body 22 (or to the pole face of a flux guide emanating therefrom), then application of a data-modulated voltage to the terminal 33 can be used to encrypt the medium with the said data, by virtue of the magnetic influence of M₂ on the medium. The device can thus be used as a magnetic write head.

### Embodiment 5

Figure 4 basically shows the device of Figure 2, subsequent to some modification. In particular, a so-called "write-line" 34 has been provided against the body 22, and is separated therefrom by a layer 35 of electrically insulating material, such as SᵢO₂. In this particular case, the write line 34 extends in a direction perpendicular to the plane of the Figure, and is comprised of a conductive material such as Cu or Au, for example.

An electrical current flowing through the write line 34 will produce a magnetic field with which the direction of M₂ can be influenced; in particular, M₂ can be directionally reversed back and forth. Since M₁ is fixed, such a change in the direction of M₂ causes a change in the mutual orientation of M₁ and M₂, which can be monitored by measuring the resistance R₁₂ between the terminals 31 and 32.

In this manner, the device acts as a magnetic random-access memory in which binary data can be stored and from which they can be retrieved again: a maintained voltage corresponding to a "1" or "0" on the write line 34 produces a parallel or anti-parallel configuration of M₁ and M₂, which in turn results in a relatively low or high value of R₁₂.

If so desired, the device depicted in Figure 4 can be incorporated into an array of such devices, so as to be able to store and retrieve multiple data bits.

## Claims

1. A magneto-electronic device comprising a substrate (1) on which a first (21) and a second (22) body of magnetic material are provided, whereby the magnetization of at least the second body is not fixed, **characterized in that** the two bodies are substantially coplanar and mutually isolated, and that the bodies are mutually connected via a layer (3) of semiconductor material in which a quasi-two-dimensional electron gas can be generated, as to form a lateral configuration.

2. A device according to Claim 1, **characterized in that** the magnetization direction of the first body is fixed.

3. A device according to Claim 2, **characterized in that** the first and second body are mutually magnetically coupled.

4. A device according to Claim 2, **characterized in that** the first and second body are not mutually magnetically coupled.

5. A device according to any of the Claims 1-4, **characterized in that** an electrode is provided against the layer of semiconductor material.

6. A device according to Claim 5, **characterized in that** the electrode is electrically insulated from the layer of semiconductor material.

7. A device according to any of the Claims 1-6, **characterized in that** the semiconductor material comprises InAs.

8. A magnetic field sensor comprising a device as claimed in any of the Claims 1-7.

9. A magnetic write head comprising a device as claimed in any of the Claims 1-8.

10. A magnetic random-access memory comprising a device as claimed in any of the Claims 1-7.

## Patentansprüche

1. Magnetoelektronische Vorrichtung mit einem Substrat (1), auf welchem ein erster (21) und ein zweiter (22) Körper aus Magnetmaterial vorgesehen sind, wobei zumindest die Magnetisierung des zweiten Körpers nicht festgelegt ist, **dadurch gekennzeichnet, dass** die beiden Körper im Wesentlichen koplanar und gegenseitig isoliert sind, und dass die Körper über eine Schicht (3) aus Halbleitermaterial, in welcher ein quasizweidimensionales Elektronengas erzeugt werden kann, miteinander verbunden sind, um eine laterale Anordnung zu bilden.

2. Vorrichtung nach Anspruch 1, **dadurch gekennzeichnet, dass** die Magnetisierungsrichtung des ersten Körpers festgelegt ist.

3. Vorrichtung nach Anspruch 2, **dadurch gekennzeichnet, dass** der erste und zweite Körper miteinander magnetisch verbunden sind.

4. Vorrichtung nach Anspruch 2, **dadurch gekennzeichnet, dass** der erste und zweite Körper nicht miteinander magnetisch verbunden sind.

5. Vorrichtung nach einem der Ansprüche 1 bis 4, **dadurch gekennzeichnet, dass** eine Elektrode gegen die Schicht aus Halbleitermaterial vorgesehen ist.

6. Vorrichtung nach Anspruch 5, **dadurch gekennzeichnet, dass** die Elektrode von der Schicht aus Halbleitermaterial elektrisch isoliert ist.

7. Vorrichtung nach einem der Ansprüche 1 bis 6, **dadurch gekennzeichnet, dass** das Halbleitermaterial InAs enthält.

8. Magnetfeldsensor, welcher eine Vorrichtung nach einem der Ansprüche 1 bis 7 aufweist.

9. Magnetschreibkopf, welcher eine Vorrichtung nach einem der Ansprüche 1 bis 8 aufweist.

10. Magnetspeicher mit wahlfreiem Zugriff, welcher eine Vorrichtung nach einem der Ansprüche 1 bis 7 aufweist.

## Revendications

1. Dispositif magnéto-électronique comprenant un substrat (1) sur lequel sont prévus un premier (21) et un second corps (22) en matériau magnétique, la magnétisation d'au moins le second corps n'étant pas fixe, **caractérisé en ce que** les deux corps sont sensiblement coplanaires et mutuellement isolés, et **en ce que** les corps sont connectés mutuellement par l'intermédiaire d'une couche (3) en matériau semi-conducteur dans laquelle un gaz d'électrons quasi bidimensionnel peut être généré de manière à constituer une configuration latérale.

2. Dispositif selon la revendication 1, **caractérisé en ce que** la direction de magnétisation du premier corps est fixe.

3. Dispositif selon la revendication 2, **caractérisé en ce que** les premier et second corps sont couplés magnétiquement l'un à l'autre.

4. Dispositif selon la revendication 2, **caractérisé en ce que** les premier et second corps ne sont pas couplés magnétiquement l'un à l'autre.

5. Dispositif selon l'une quelconque des revendications précédentes 1 à 4, **caractérisé en ce qu'**une électrode est disposée contre la couche en matériau semi-conducteur.

6. Dispositif selon la revendication 5, **caractérisé en ce que** l'électrode est isolée électriquement de la couche en matériau semi-conducteur.

7. Dispositif selon l'une quelconque des revendications précédentes 1 à 6, **caractérisé en ce que** le matériau semi-conducteur comprend InAs.

8. Détecteur de champ magnétique comprenant un dispositif selon l'une quelconque des revendications précédentes 1 à 7.

9. Tête d'écriture magnétique comprenant un dispositif selon l'une quelconque des revendications précédentes 1 à 8.

10. Mémoire vive magnétique comprenant un dispositif selon l'une quelconque des revendications précédentes 1 à 7.
